Europäisches Patentamt

European Patent Office

Office européen des brevets

(19)

(11) Veröffentlichungsnummer: **0 415 485 A2**

## (12) EUROPÄISCHE PATENTANMELDUNG

(21) Anmeldenummer: **90202256.5**

(22) Anmeldetag: **22.08.90**

(51) Int. Cl.5: **H01H 47/32**

(30) Priorität: **26.08.89 DE 3928281**

(43) Veröffentlichungstag der Anmeldung:
**06.03.91 Patentblatt 91/10**

(84) Benannte Vertragsstaaten:
**DE FR GB IT NL**

(71) Anmelder: **Philips Patentverwaltung GmbH**
**Wendenstrasse 35 Postfach 10 51 49**
**W-2000 Hamburg 1(DE)**
(84) **DE**

Anmelder: **N.V. Philips' Gloeilampenfabrieken**

**Groenewoudseweg 1**
**NL-5621 BA Eindhoven(NL)**
(84) **FR**

(72) Erfinder: **van der Broeck, Heinz, Dr.**
**Brüsseler Strasse 25**
**W-5352 Zülpich(DE)**

(74) Vertreter: **von Laue, Hanns-Ulrich et al**
**Philips Patentverwaltung GmbH,**
**Wendenstrasse 35, Postfach 10 51 49**
**W-2000 Hamburg 1(DE)**

(54) **Anordnung zur Erzeugung von Strompulsen vorgegebener Form in einem induktiven Verbraucher.**

(57) Bei einer Anordnung zur Erzeugung von Strompulsen vorgegebener Form mit hoher Flankensteilheit in wenigstens einem induktiven Verbraucher, insbesondere einer Gradientenspule zur Kernspintomographie, ist vorgesehen, daß eine Versorgungsspannung mit konstantem Wert in gepulster Form an eine Reihenschaltung einer Hilfsinduktivität und des Verbrauchers, dem mittels Steuerelementen steuerbare Stromsenken parallel geschaltet sind, angelegt wird, wobei die Spannung in der Weise gepulst wird, daß während der Impulsflanken des Verbraucher-Soll-Stromes ein gegenüber diesem schnellerer Auf- bzw. Abbau des Stromes durch die Parallelschaltung erfolgt und daß die Versorgungsspannung in der Weise gepulst wird, daß der Strom durch die Parallelschaltung während Impuls-Vorderflanken des Verbraucher-Soll-Stromes und zu Zeiten konstanten Verbraucher-Soll-Stromes jederzeit größer und während Impuls-Rückflanken des Verbraucher-Soll-Stromes jederzeit kleiner ist als der Verbraucher-Soll-Strom und mittels der Steuerelemente ein solcher Strom durch die Stromsenke geleitet wird, daß der Strom durch den Verbraucher jederzeit seinen Soll-Wert aufweist.

FIG.1

# ANORDNUNG ZUR ERZEUGUNG VON STROMPULSEN VORGEGEBENER FORM IN EINEM INDUKTIVEN VERBRAUCHER

Die Erfindung betrifft eine Anordnung zur Erzeugung von Strompulsen vorgegebener Form mit hoher Flankensteilheit in wenigstens einem induktiven Verbraucher, insbesondere einer Gradientenspule zur Kernspintomographie, unter Einsatz einer Versorgungsspannung.

Soll in einem induktiven Verbraucher ein Strompuls vorgegebener Form und Amplitude mit hoher Flankensteilheit erzeugt werden, so bestimmt sich die Größe der dafür erforderlichen Versorgungsspannung nach derjenigen Spannung, die erforderlich ist, um einen Stromaufbau bzw. -abbau zu bewirken. In den Zeiten, in denen ein konstanter Strom durch die Spule fließt, wird dagegen eine deutlich kleinere Spannung benötigt. Infolgedessen ergibt sich die Problematik, daß die Versorgungsspannung für den Stromaufbau bzw. -abbau recht groß ausgelegt werden muß.

Bei den Anordnungen nach dem Stande der Technik sind meist in Reihenschaltung zu dem induktiven Verbraucher Längsregler vorgesehen, in der Regel Transistoren, mittels welcher der benötigte Stromfluß eingestellt wird. Dabei fällt die Differenz zwischen der Versorgungsspannung und der Spannung am induktiven Verbraucher an diesen Längsregler ab und verursacht große Verluste. Dies insbesondere während der Zeiten, in denen ein konstanter Stromfluß eingestellt werden soll, da ja insbesondere zu diesen Zeiten die Versorgungsspannung an sich sehr viel größer ist als erforderlich.

Nach dem Stande der Technik ist ferner eine zweite Lösung bekannt, bei der die Versorgungsspannung entweder auf verschiedene Werte umschaltbar ist oder bei der ein Schaltnetzteil vorgesehen ist, um die erforderliche Versorgungsspannung laufend anzupassen. In beiden Fällen muß jedoch immer eine ausreichende Spannungsreserve für die Längsregler vorgesehen werden. Bei der Lösung mit verschiedenen Spannungen (z.B. EP 0 250 718 A1) sind viele Schalter und Spannungsquellen erforderlich, die alle für den Maximalstrom auszulegen sind, wodurch der Aufwand stark erhöht wird. Auch bei Anordnungen nach dieser Lösung entstehen noch hohe Verluste.

Es ist Aufgabe der Erfindung, bei Anordnungen der eingangs genannten Art den Wirkungsgrad weiter zu verbessern.

Diese Aufgabe ist für derartige Anordnungen dadurch gelöst, daß
- in Reihenschaltung zum Verbraucher eine Hilfsinduktivität und in Parallelschaltung zum Verbraucher wenigstens eine, mittels Steuerelementen steuerbare Stromsenke vorgesehen ist,

- die Versorgungsspannung mittels der Anordnung in gepulster Form und erforderlicher Polarität an die Reihenschaltung anlegbar ist,
- die Versorgungsspannung in der Weise gepulst wird, daß der Strom durch die Parallelschaltung während Impuls-Vorderflanken des Verbraucher-Soll-Stromes und zu Zeiten konstanten Verbraucher-Soll-Stromes größer und während Impuls-Rückflanken des Verbraucher-Soll-Stromes kleiner ist als der Verbraucher-Soll-Strom, und
- mittels der Steuerelemente ein solcher Strom durch die Stromsenke geleitet wird, daß der Strom durch den Verbraucher jederzeit seinen Soll-Wert aufweist.

Die Versorgungsspannung weist bei dieser erfindungsgemäßen Lösung einen konstanten Wert auf und kann mittels der Anordnung in beiden Polaritäten an den induktiven Verbraucher angelegt werden. Selbstverständlich kann die Spannungsquelle auch völlig abgeschaltet werden. Die Versorgungsspannung wird in gepulster Form angelegt, d.h. also zwischenzeitlich immer wieder abgeschaltet.

Parallel zu dem induktiven Verbraucher ist wenigstens eine steuerbare Stromsenke vorgesehen. Steuerbar bedeutet dabei, daß der durch die Stromsenke fließende Strom von außen steuerbar ist.

Die in der oben beschriebenen Weise gepulste Versorgungsspannung wird an die Reihenschaltung einer Hilfsinduktivität mit dieser Parallelschaltung aus dem induktiven Verbraucher und der oder den Stromsenken angelegt. Da die Versorgungsspannung in gepulster Form angelegt wird, hat der Gesamtstrom durch die Parallelschaltung einen dreiecksförmigen Verlauf.

Dabei ist jedoch darauf zu achten, daß der Strom durch die Parallelschaltung während der Impuls-Vorderflanken des Verbraucher-Soll-Stromes und während Zeiten eines konstanten Verbraucher-Soll-Stromes jederzeit größer ist als der Wert des Verbraucher-Soll-Stromes. Ferner soll während der Impuls-Rückflanken des Verbraucher-Soll-Stromes der Strom durch die Parallelschaltung jederzeit kleiner sein als der Verbraucher-Soll-Strom. Bei einem Impuls des Verbraucher-Soll-Stromes positiver Polarität soll also an der Anstiegsflanke und während der Zeit des Impulsdaches der Strom durch die Parallelschaltung jederzeit größer sein als der Verbraucher-Soll-Strom. An der negativen, abfallenden Flanke dieses positiven Impulses des Verbraucher-Soll-Stromes soll dagegen der Ist-Strom durch die Parallelschaltung jederzeit kleiner sein. Umgekehrt ist bei einem Impuls des Verbraucher-Soll-Stromes mit negativer Polarität darauf zu achten, daß an der abfallenden Vorderflanke des Impulses des Verbraucher-Soll-Stroms der Strom durch die Parallelschaltung jederzeit betragsmäßig größer ist, d.h. also einen größeren negativen Wert aufweist. Das gleiche gilt für diejenige Zeit, in der der Soll-Wert des Verbraucherstroms konstant ist. An der Rückflanke des negativen Impulses dagegen soll der Strom durch die Parallelschaltung einen kleineren Wert aufweisen als der Verbraucher-Soll-Strom.

Bei diesen Vorgaben ist zu berücksichtigen, daß diese insbesondere im Übergang von einem konstanten Verbraucher-Soll-Strom zu einer Rückflanke eines Impulses des Verbraucher-Soll-Stromes kurzzeitig nicht immer einhaltbar sind, da der Strom durch die Induktivität sich in diesem Übergang gegebenenfalls nicht so schnell ändert, daß schon mit Beginn der Rückflanke der Strom durch die Parallelschaltung kleiner ist als der Verbraucher-Soll-Strom. Jedoch ist in diesen Fällen die Versorgungsspannung so zu pulsen, daß der angestrebte Zustand möglichst schnell erreicht wird.

Die in Reihenschaltung zum Verbraucher vorgesehene Hilfsinduktivität dient vor allem dazu, den Wechselstromanteil der gepulsten Versorgungsspannung aufzunehmen.

Die Differenz zwischen dem durch die Parallelschaltung fließenden Strom und dem Sollstrom durch den induktiven Verbraucher wird durch die Stromsenke geleitet. Auf diese Weise fließt durch den induktiven Verbraucher der Strom in Höhe seines Sollwertes.

Diese erfindungsgemäße Anordnung weist gegenüber den Anordnungen nach dem Stande der Technik einen wesentlich verbesserten Wirkungsgrad auf. Bei den, insbesondere für Gradientenspulen zur Kernspintomographie, in Rede stehenden Größenordnungen des Stromes von einigen 100 A ist dies eine wesentliche Verbesserung.

Die Hauptursache für die Verbesserung liegt darin, daß die Versorgungsspannung nicht mehr geregelt werden muß, sondern in gepulster Form über die Hilfsinduktivität an den Verbraucher angelegt wird. Es sind daher keine Längsregler oder ähnliches mehr erforderlich, sondern es können elektronische Schalter eingesetzt werden, die einen hohen Wirkungsgrad aufweisen. Die Stromsenke wird nur mit relativ kleinen Strömen belastet, so daß auch die hier auftretenden Verluste relativ gering sind. Darüber hinaus ist der Spannungsabfall in dieser Stromsenke insbesondere bei konstantem Strom relativ klein.

Aufgrund der geringeren Verluste benötigt die erfindungsgemäße Anordnung weniger Kühlungsaufwand und kann daher kompakter gebaut werden.

Nach einer weiteren Ausgestaltung der Anordnung ist vorgesehen, daß die Versorgungsspannung mittels von einer Steuerschaltung angesteuerter elektronischer Schalter in erforderlicher Polarität in gepulster Form an die Reihenschaltung der Hilfsinduktivität mit der Parallelschaltung anlegbar ist und daß der Steuerschaltung zur Bestimmung der erforderlichen Polarität und Pulsbreite ein Differenzsignal aus dem Verbraucher-Soll-Strom und dem Ist-Strom durch die Parallelschaltung sowie ein Signal zugeführt ist, das gegebenenfalls das Vorzeichen der geraden erfolgenden Stromänderung im Verbraucher angibt.

Die Versorgungsspannung kann mittels Transistoren, die im reinen Schaltbetrieb arbeiten, angelegt werden. Dabei entstehen relativ geringe Verluste. Die Breite und der Abstand der Pulse wird mittels einer Steuerschaltung bestimmt und gesteuert. Zur Bestimmung der erforderlichen Pulse ist der Steuerspannung die Differenz aus dem durch die Parallelschaltung fließenden Gesamtstrom und dem Sollstrom durch den Verbraucher zugeführt. Darüber hinaus erhält die Steuerschaltung ein Signal, welches angibt, welches Vorzeichen eine gegebenenfalls gerade erfolgende Stromänderung im Verbraucher hat. Aus diesen beiden Eingangssignalen kann die Steuerschaltung die Versorgungsspannung in Pulsen in der Weise an die Reihenschaltung aus Hilfsinduktivität und Parallelschaltung anlegen, daß die oben angegbenen Bedingungen immer erfüllt sind.

Nach einer weiteren Ausgestaltung der Erfindung ist vorgesehen, daß das Signal, das das Vorzeichen der erfolgenden Stromänderung angibt, die Übergänge von einem konstanten Verbraucher-Soll-Strom zu einer Rückflanke eines Impulses dieses Stroms zeitlich bereits so früh angibt, daß mit Beginn der Rückflanke der Strom durch die Parallelschaltung bereits kleiner ist als der Verbraucher-Soll-Strom.

Wie oben bereits erwähnt, können sich in dem Übergang von einem konstanten Verbraucher-Soll-Strom zu einer Rückflanke eines Impulses dieses Stromes Probleme dadurch ergeben, daß mit Beginn der Rückflanke der während der Zeit des konstanten Verbraucher-Soll-Stromes noch größere Strom durch die Parallelschaltung nicht mit Beginn der Rückflanke bereits kleiner sein kann als der Verbraucher-Soll-Strom. Um diese letzte Forderung jedoch zu erfüllen, gibt das Signal, das das Vorzeichen der erfolgenden Stromänderung angibt, Übergänge von einem konstanten Verbraucher-Soll-Strom zu einer Rückflanke eines Impulses dieses Stromes bereits verfrüht an. Infolgedessen wird mittels der Anordnung die gepulste Versorgungsspannung bereits frühzeitig in erforderlicher Weise generiert. Dies bedeutet im Regelfall, daß die Polarität der Versorgungsspannung gewechselt wird, damit mit Beginn der Rückflanke des Verbraucher-Soll-Stromes der Ist-Strom durch die Parallelschaltung bereits kleiner ist als dieser.

Nach einer weiteren Ausgestaltung der Erfindung ist vorgesehen, daß die Steuerelemente in der bzw. den Stromsenke(n) elektronische Regler darstellen, denen das Differenzsignal aus dem Verbraucher-Soll-Strom und dem Ist-Strom durch die Parallelschaltung zugeführt ist und die in Abhängigkeit dieses Signals den Wert des durch die Stromsenke(n) fließenden Stromes beeinflussen.

Als Steuerelemente in der bzw. den Stromsenken eignen sich elektronische Regler, d.h. also insbesondere Transistoren, die vorzugsweise Feldeffekttransistoren sind, die in Abhängigkeit des oben beschriebenen Differenzsignals gesteuert werden, wodurch der durch die Stromsenke fließende Strom in gewünschter Weise beeinflußt wird.

Nach einer weiteren Ausgestaltung ist vorgesehen, daß zwei Stromsenken vorgesehen sind, welche je eine Diode aufweisen, die so verschaltet sind, daß für jede Stromflußrichtung jeweils nur eine Stromsenke wirksam ist.

Setzt man als Steuerelemente in den Stromsenken Transistoren ein, so ist bei dieser Anordnung üblicherweise nur ein Stromfluß in eine Stromrichtung möglich. Es sind deshalb zwei Stromsenken vorgesehen, welche antiparallel geschaltet sind.

Nach einer weiteren Ausgestaltung der Erfindung ist vorgesehen, daß zur Aufrechterhaltung der Funktion der Steuerelemente bei niedriger an den Verbracher abfallender Spannung in den Stromsenken je eine Spannungsquelle vorgesehen ist. Auf diese Weise arbeiten die Stromsenken auch bei relativ geringen, an dem Verbraucher abfallenden Spannungen. Sie können selbst noch bei kleinen, negativen Verbraucherspannungen eingesetzt werden und werden dann zur Stromquelle.

Anhand der Zeichnung wird ein Ausführungsbeispiel der Erfindung näher erläutert. Es zeigen:

Fig. 1 eine Schaltungsanordnung zur Erzeugung von Strompulsen in einem induktiven Verbraucher,

Fig. 2 bis 5 Spannungs- bzw. Stromdiagramme für die Schaltungsanordnung nach Fig. 1.

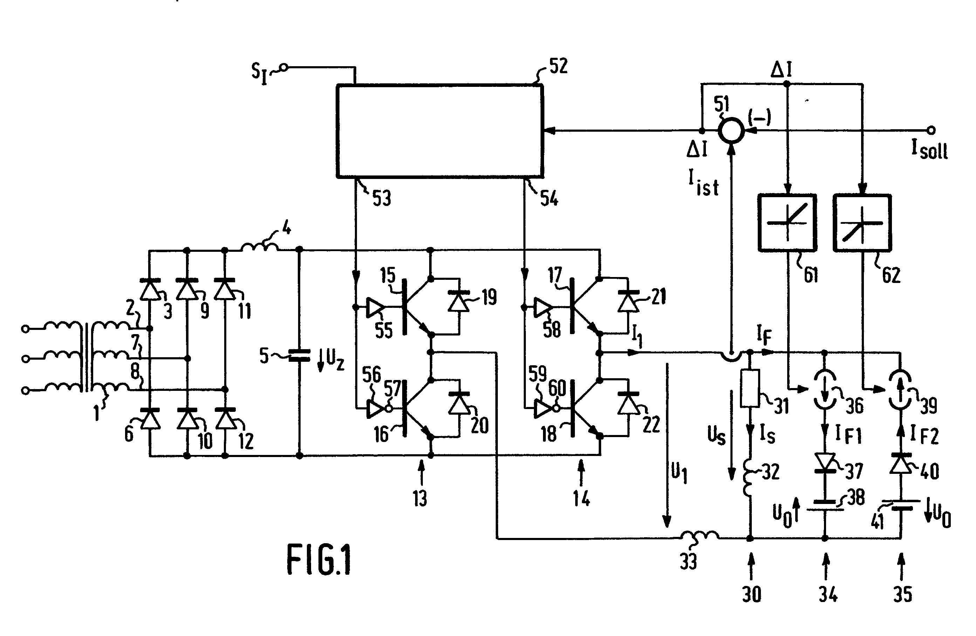

In der in Fig. 1 dargestellten Anordnung wird die Versorgungsspannung mittels eines Drehstromtransformators 1 erzeugt, dessen Ausgangsspannung gleichgerichtet wird. Die erste sekundärseitige Phase 2 des Transformators 1 ist über eine Diode 3 und eine Induktivität 4 auf eine Elektrode der Kapazität 5 geschaltet, deren andere Elektrode über eine weitere Diode 6 ebenfalls mit der sekundärseitigen Phase 2 des Drehstromtransformators 1 verbunden ist. Die Diode 3 und 6 sind dabei so geschaltet, daß die Anode der Diode 3 und die Kathode der Diode 6 mit der Sekundärphase 2 des Transformators verbunden sind.

Der Drehstromtransformator 1 weist ferner eine zweite sekundärseitige Wicklung 7 und eine dritte sekundärseitige Wicklung 8 auf. Die zweite sekundärseitige Wicklung 7 ist in entsprechender Weise wie die erste sekundärseitige Wicklung 2 über Dioden 9 und 10 und die Induktivität 4 mit der Kapazität 5 verbunden. Entsprechendes gilt für die dritte sekundärseitige Phase 8 bezüglich Dioden 11 und 12.

Durch diese Gleichrichterschaltung wird die Kapazität 5 aufgeladen. An der Kapazität 5 kann dann die näherungsweise konstante Versorgungsspannung $U_z$ entnommen werden.

Der Kapazität 5 sind zwei Transistorzweige 13 und 14 parallelgeschaltet. Der erste Transistorzweig 13 weist einen ersten Transistor 15 und einen zweiten Transistor 16 auf. Der Kollektor des Transistors 15 ist mit der ersten Elektrode der Kapazität 5 verbunden. Der Emitter des Transistors 15 ist mit dem Kollektor des Transistors 16 verbunden, dessen Emitter mit der anderen Elektrode der Kapazität 5 verbunden ist.

In gleicher Weise sind zwei Transistoren 17 und 18 der zweiten Transistorbrücke 14 verschaltet.

Alle vier Transistoren 15, 16, 17 und 18 sind mit Dioden 19, 20, 21 und 22 versehen, deren Kathoden mit den Kollektoren und deren Anoden mit den Emittern des jeweiligen Transistors verbunden sind. Diese Dioden dienen als Freilaufdioden.

Der Verbindungspunkt zwischen dem Emitter des Transistors 17 und dem Kollektor des Transistors 18 ist auf einen induktiven Verbraucher 30 geführt, der in dem in der Fig. 1 dargestellten Schaltbild von einem ohmschen Widerstand 31 und einer Induktivität 32 repräsentiert wird. Dieser Verbraucher ist über eine weitere, äußere Hilfsinduktivität 33 mit dem Verbindungspunkt zwischen dem Emitter des Transistors 15 und dem Kollektor des Transistors 16 verbunden.

Dem induktiven Verbraucher 30, d.h. also der Reihenschaltung aus dem ohmschen Widerstand 31 und der Induktivität 32 sind zwei Stromsenken 34 und 35 parallelgeschaltet. Die erste Stromsenke 34, die vorgesehen ist für einen Stromfluß von der Brücke aus den Transistoren 17 und 18 zu der Brücke mit den Transistoren 15 und 16, weist ein elektronisches Steuerelement 36, eine Diode 37, deren Anode mit dem elektrischen Steuerelement 36 verbunden ist, sowie eine Spannungsquelle 38 auf.

Die zweite Stromsenke 35 ist für ein Stromfluß in umgekehrter Richtung vorgesehen und weist dazu ein elektronisches Steuerelement 39, eine Diode 40 sowie eine Spannungsquelle 41 auf. Auch in der Stromsenke 35 sind diese Bauelemente in Reihe geschaltet, jedoch antiparallel zu der Stromsenke 34.

Der durch die Parallelschaltung aus dem Verbraucher 30 und den beiden Stromsenken 34 und 35 fließende Strom wird durch ein Signal $I_{ist}$ angegeben, das einem Addierer 51 zugeführt ist. Dem Addierer 51 ist ferner von außen ein Signal $I_{soll}$ mit negativem Vorzeichen zugeführt, das laufend den Sollwert des Stromes für den Verbraucher 30 angibt. Das Ausgangssignal des Addierers 51 ist zum einen einer elektronischen Steuerschaltung 52 zugeführt. Die elektronische Steuerschaltung 52 weist einen weiteren Eingang auf, dem ein Steuersignal $S_I$ zugeführt ist, daß das Vorzeichen einer zeitlichen Stromänderung und somit das erforderliche Vorzeichen der gepulsten Versorgungsspannung angibt. Die Steuerschaltung 52 weist ferner zwei Ausgänge 53 und 54 auf. Der erste Ausgang 53 ist über einen Verstärker 55 mit der Basis des Transistors 15 und außerdem über einen Verstärker 56 und einen Inverter 57 mit der Basis des Transistors 16 verbunden. Der zweite Ausgang 54 ist in entsprechender Weise über einen Verstärker 58 mit der Basis des Transistors 17 sowie über einen Verstärker 59 und einen Inverter 60 mit der Basis des Transistors 18 verbunden.

Das Ausgangssignal des Addierers 51 ist ferner zwei Begrenzern 61 und 62 zugeführt, deren Ausgangssignale auf die Steuerelemente 36 bzw. 39 der Stromsenken 34 bzw. 35 geführt sind.

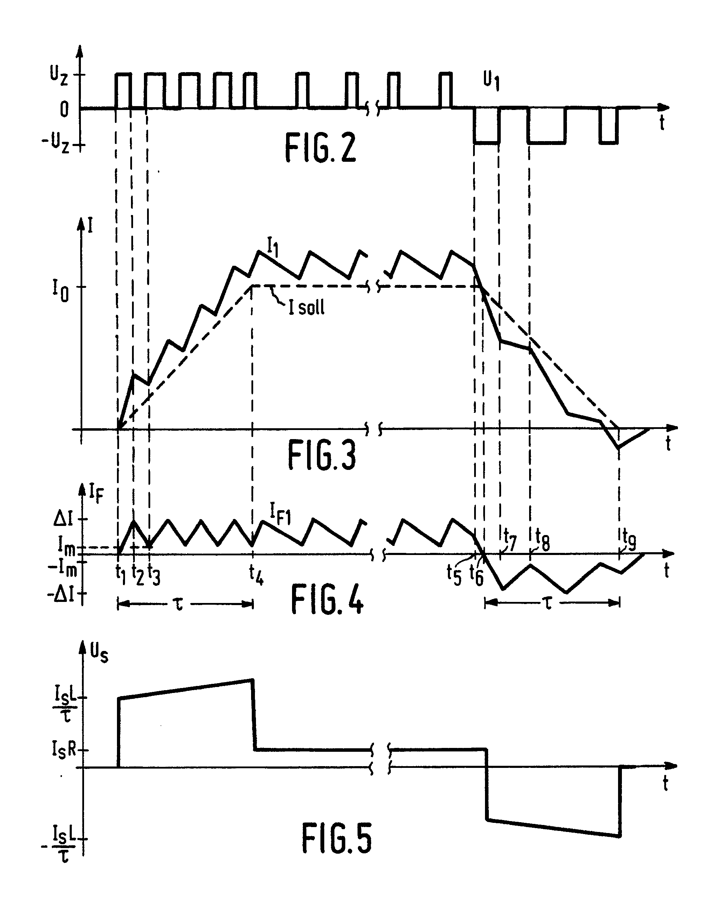

Im folgenden wird die Funktionsweise der in der Fig. 1 dargestellten Anordnung anhand der in den Fig. 2, 3, 4 und 5 dargestellten Strom- bzw. Spannungsverläufe näher erläutert.

Die Kapazität 5 ist mittels des Drehstromtransformators 1 sowie der nachgeschalteten Gleichrichteranordnung auf die Versorgungs-Gleichspannung $U_z$ aufgeladen. Mittels der elektronischen Steuerschaltung 52, bzw. der an ihren Ausgängen 53 bzw. 54 anliegenden Signale, ist diese Versorgungsspannung mittels der Transistoren 19 bis 22 auf die Reihenschaltung der Hilfsinduktivität 33 mit der Parallelschaltung des induktiven Verbrauchers 30 und der beiden Stromsenken 34 und 35 schaltbar. Für einen postiven Strom $I_1$ durch den Verbraucher 30, an dessen Reihenschaltung des ohmschen Widerstandes 31 und der Induktivität 32 die Spannung $U_s$ abfällt, sind der Transistor 17 sowie der Transistor 16 zu aktivieren, d.h. leitend zu schalten. Für einen negativen Strom $I_1$ durch den Verbraucher 30 sind dagegen die Transistoren 15 und 18 leitend zu schalten.

Die Versorgungsspannung $U_z$ wird nun aber nicht dauernd an den Verbraucher 30 geschaltet, sondern dies geschieht in gepulster Form, wie dies in Fig. 2 dargestellt ist. Es ist dort der Strom $I_1$ dargestellt, der durch die Parallelschaltung fließt.

Die elektronische Steuerschaltung 52 muß dabei laufend den Abstand und die Breite der Spannungspulse, die an die Parallelschaltung geschaltet werden, bestimmen. Dazu ist der elektronischen Steuerschaltung 52 das Differenzsignal i zugeführt, das die Differenz aus dem tatsächlich durch die Parallelschaltung des induktiven Verbrauchers 30 und der beiden Stromsenken 34 und 35 fließenden Stroms und dem Soll-Strom durch den induktiven Verbraucher 30 angibt. Dieses Signal i gibt also an, um wieviel der Strom durch die Parallelschaltung von dem Soll-Strom durch den Verbraucher abweicht. Aus diesem Signal i und dem Signal Si, das das Vorzeichen der zeitlichen Änderung des Soll-Stroms durch den Verbraucher und somit das erforderliche Vorzeichen der gepulsten Versorgungsspannung angibt, bestimmt die Steuerschaltung 52 die Polarität, den Abstand und die Breite der Spannungspulse, die an die Parallelschaltung angelegt werden, in der Weise, daß für Zeiten, in denen ein konstanter Strom $I_{soll}$ fließt, der Strom $I_1$ durch die Parallelschaltung jederzeit größer ist als der Strom $I_{soll}$. In der Fig. 3 gilt dies beispielsweise für den Zeitraum t4 bis t5. Während der Zeit der positiven Anstiegsflanke des Strompulses, also in der Zeit t1 bis t5 nach Fig. 3, ist ebenfalls darauf zu achten, daß der Strom I1 durch die Parallelschaltung jederzeit größer ist als der Strom $I_{soll}$. Während der Zeit der Rückflanke des Verbraucher-Soll-Stromes, also in der Zeit t6 bis t9, werden dagegen die Strompulse in ihrer Polarität, in ihrer Breite und in ihrem Abstand so gewählt, daß der Strom I1 durch die Parallelschaltung jederzeit kleiner ist als der Strom $I_{soll}$.

Der infolgedessen durch die Parallelschaltung fließende Gesamtstrom $I_1$ nimmt einen dreieckförmigen Verlauf an, wie dies in Fig. 3 angedeutet ist. Um nun aber durch den induktiven Verbraucher 30 nicht diesen dreiecksförmigen Strom $I_1$ sondern tatsächlich den Strom $I_{soll}$ fließen zu lassen, sind dem induktiven Verbraucher die beiden Stromsenken 34 und 35 parallelgeschaltet.

Diese Stromsenken 34 und 35 sind mittels der Steuerelemente 36 bzw. 39 steuerbar, d.h. der Wert des Stromes, der durch die Stromsenken fließt, ist mittels dieser Steuerelemente einstellbar. Dazu ist den Steuerelementen 36 bzw. 39 das Signal i, dessen Herleitung oben beschrieben wurde, über Begrenzer 61 bzw. 62 zugeführt. Diese haben dabei insbesondere die Aufgabe, den beiden Steuerelementen das Signal i mit dem jeweils richtigen Vorzeichen zuzuführen, da ja für positiven Strom $I_1$ das Steuerelement 36 und für negativen Strom $I_1$ das Steuerelement 39 aktiviert sein soll.

Dies geschieht nun in der Weise, daß in Abhängigkeit des Signales i das jeweilige Steuerelement 36 bzw. 39 so gesteuert wird, daß genau der Differenzstrom zwischen dem durch die Parallelschaltung fließenden Strom $I_1$ und dem Strom $I_{soll}$ durch den Verbraucher 30 durch die jeweils aktivierte Stromsenke 34 bzw. 35 fließt. Dies hat dann zur Folge, daß durch den induktiven Verbraucher 30 genau der Soll-Strom fließt.

In dem in den Fig. 2 bis 5 dargestellten Zeitraum, in dem ein positiver Strompuls erzeugt wird, ist an der Anstiegsflanke, d.h. also in dem Zeitraum t1 bis t4 die Stromsenke 36 und an der Abstiegsflanke, d.h. also in dem Zeitraum t5 bis t9, die Stromsenke 39 aktiviert. Zur Zeit des positiven, konstanten Stromflußes in der Zeit t4 bis t5 ist die Stromsenke 36 aktiviert.

Im folgenden soll anhand des Zeitraumes t1 bis t3 in den Fig. 2 bis 4 der oben beschriebene Regelvorgang in der Anordnung noch einmal im einzelnen erläutert werden:

Zum Zeitpunkt t1 beginnt die positive Flanke des Stromes $I_{soll}$ durch den Verbraucher 30. Es wird daher von der elektronischen Steuerschaltung 52 die positive Versorgungsspannung $U_z$ mittels der Transistoren 17 und 16 an die Reihenschaltung der Hilfsinduktivität 33 mit der Parallelschaltung des Verbrauchers 30 und der beiden Stromsenken 34 und 35 geschaltet. Infolgedessen entsteht der in Fig. 3 dargestellte Stromanstieg bis zum Zeitpunkt t2, der sehr viel stärker ist, als der Anstieg des Stromes $I_{soll}$ in der gleichen Zeit. Zum Zeitpunkt t2 wird dann die Spannung $U_z$ abgeschaltet. Es tritt dann ein Freilauf ein. Infolgedessen fällt der Strom $I_1$ durch die Parallelschaltung wieder leicht ab. Zum Zeitpunkt t3, in dem der Strom $I_1$ noch größer sein muß, als der Strom $I_{soll}$, wird dann wieder die Versorgungsspannung $U_z$ an die Reihenschaltung gelegt. Es wiederholt sich dann der Vorgang aus den Zeiten t1 bis t3. Gleiches gilt für den Zeitraum t4 bis t5.

In der Fig. 4 ist der Differenzstrom i aus dem in der Fig. 3 dargestellten Strom $I_1$ und dem Strom $I_{soll}$ durch den Verbraucher dargestellt. Mittels dieses Stromes i wird in dem vorliegenden Beispiel während des Zeitraums t1 bis t5 die Stromsenke 36 aktiviert. Dies geschieht gesteuert durch den Strom i in der Weise, daß durch den Verbraucher 30 der gewünschte Soll-Strom fließt. Es fließt dann durch die Stromsenke 34 ein dreiecksförmiger Strom, der den in Fig. 4 dargestellten Verlauf hat.

Für die Zeiten t6 bis t8, d.h. also während der Rückflanke des Strompulses soll der Strom $I_1$ jederzeit kleiner sein als der Strom $I_{soll}$.

Zum Zeitpunkt t6, d.h. also zu Beginn der negativen Flanke muß daher spätestens diese Bedingung erfüllt sein. In dem in der Figur dargestellten Ausführungsbeispiel wird sogar etwas vorher, zum Zeitpunkt t5, diese negative Flanke bereits vorbereitet. Dies geschieht, damit sofort nach dem Zeitpunkt t6 der Strom $I_1$, bereits kleiner ist als $I_{soll}$. Zu diesem Zeitpunkt t5 erhält die Steuerschaltung 52 ein Signal Si, das eine negative Flanke angibt. Es wird daher mittels der Transistoren 15 und 18 eine negative Spannung $U_z$ an die Reihenschaltung angelegt. Infolgedessen fällt der Strom $I_1$ sehr schnell ab bis zum Zeitpunkt t7, wo er bereits deutlich geringer ist als der Strom $I_{soll}$. Die zeitliche Änderung des Stromes $I_1$ ist in dieser Zeit deutlich größer als die zeitliche Änderung des Stromes $I_{soll}$. Zum Zeitpunkt t7 wird dann die Versorgungsspannung wieder abgeschaltet, so daß bis zum Zeitpunkt t8 der Strom $I_1$ langsamer abfällt. Noch bevor der Strom $I_1$ wieder die Größe des Stromes $I_{soll}$ erreicht, wird wieder die negative Versorgungsspannung $U_z$ an die Reihenschaltung angeschaltet. Dieser Vorgang wiederholt sich dann bis zum Ende der negativen Flanke, also bis zum Zeitpunkt t9.

Während der Zeit t6 bis t9 wird das Signal i, das in Fig. 4 dargestellt ist, in entsprechender Weise zur Steuerung der Stromsenke 39 herangezogen, wie dies in der Zeit t1 bis t4 für die Steuerung der Stromsenke 36 geschieht. Während der Zeit der negativen Flanke des Stromes $I_{soll}$ wird also mittels der Stromsenke 35 der Soll-Strom durch den Verbraucher in vorgegebener Höhe eingestellt.

Für den gesamten Zeitraum t1 bis t9 ist in Fig. 5 der Verlauf der Spannung $U_s$ an dem induktiven Verbraucher, d.h. also der Reihenschaltung des ohmschen widerstandes 31 und der Induktivität 32, dargestellt. In dem Zeitraum t1 bis t4 bzw. t6 bis t9, also den Zeiträumen der Stromänderung ist diese Spannung deutlich größer als in den Zeiträumen, in denen ein konstanter Strom fließt, also beispielsweise im Zeitraum t4 bis t5. Dies ergibt sich infolge der Höhe des Stromes $I_{soll}$ bzw. dessen hoher Flankensteilheit und der Induktivität 32 des Verbrauchers 30.

## Ansprüche

1. Anordnung zur Erzeugung von Strompulsen vorgegebener Form mit hoher Flankensteilheit in wenigstens einem induktiven Verbraucher (30), insbesondere einer Gradientenspule zur Kernspintomographie, unter Einsatz einer Versorgungsspannung, dadurch gekennzeichnet , daß

- in Reihenschaltung zum Verbraucher (30) eine Hilfsinduktivität (33) und in Parallelschaltung zum Verbraucher (30) wenigstens eine mittels Steuerelementen (36, 39) steuerbare Stromsenke (34, 35) vorgesehen ist,

- die Versorgungsspannung mittels der Anordnung in gepulster Form und erforderlicher Polarität an die Reihenschaltung anlegbar ist,

- die Versorgungsspannung in der Weise gepulst wird, daß der Strom durch die Parallelschaltung während Impuls-Vorderflanken des Verbraucher-Soll-Stromes und zu Zeiten konstanten Verbraucher-Soll-Stromes größer und während Impuls-Rückflanken des Verbraucher-Soll-Stromes kleiner ist als der Verbraucher-Soll-Strom, und
- mittels der Steuerelemente (36, 38) ein solcher Strom durch die Stromsenke geleitet wird, daß der Strom durch den Verbraucher jederzeit seinen Soll-Wert aufweist.

2. Anordnung nach Anspruch 1,
dadurch gekennzeichnet , daß die Versorgungsspannung mittels von einer Steuerschaltung (52) angesteuerter elektronischer Schalter (15, 16, 17, 18) in erforderlicher Polarität in gepulster Form an die Reihenschaltung der Hilfsinduktivität (33) mit der Parallelschaltung anlegbar ist und daß der Steuerschaltung (52) zur Bestimmung der erforderlichen Polarität und Pulsbreite ein Differenzsignal aus dem Verbraucher-Soll-Strom und dem Ist-Strom durch die Parallelschaltung sowie ein Signal zugeführt ist, das gegebenenfalls das Vorzeichen der erfolgenden Stromänderung und somit der er-forderlichen Polarität der gepulsten Versorgungs-spannung angibt.

3. Anordnung nach Anspruch 1,
dadurch gekennzeichnet , daß das Signal, das das Vorzeichen der erfolgenden Stromänderung angibt, die Übergänge von einem konstanten Verbraucher-Soll-Strom zu einer Rückflanke eines Impulses dieses Stromes zeitlich bereits so früh angibt, daß mit Beginn der Rückflanke der Strom durch die Parallelschaltung bereits kleiner ist als der Verbraucher-Soll-Strom.

4. Anordnung nach einem der Ansprüche 1 bis 3,
dadurch gekennzeichnet , daß die Steuerelemente (36, 39) in der bzw. den Stromsenke(n) (34, 35) elektronische Regler darstellen, denen das Differenzsignal aus dem Verbraucher-Soll-Strom und dem Ist-Strom durch die Parallelschaltung zugeführt ist und die in Abhängigkeit dieses Signals den Wert des durch die Stromsenke(n) fließenden Stromes beeinflussen.

5. Anordnung nach Anspruch 4,
dadurch gekennzeichnet , daß zwei Stromsenken (34, 35) vorgesehen sind, welche je eine Diode (37, 40) aufweisen, die so verschaltet sind, daß für jede Stromflußrichtung jeweils nur eine Stromsenke wirksam ist.

6. Anordnung nach Anspruch 4 oder 5,
dadurch gekennzeichnet , daß zur Aufrechterhaltung der Funktion der Steuerelemente bei niedriger, an dem Verbraucher abfallender Spannung in den Stromsenken je eine Spannungsquelle (38, 41) vorgesehen ist.

7. Anordnung nach einem der Ansprüche 1 bis 6,
dadurch gekennzeichnet , daß die Versorgungsspannung die gleichgerichtete Ausgangsspannung eines Drehstromtransformators (1) darstellt.

FIG.1

FIG.2

FIG.3

FIG.4

FIG.5